# EUROPEAN PATENT APPLICATION

(11) **EP 2 416 359 A2**
(43) Date of publication of application: **08.02.2012**
(21) Application number: 10189614.0
(22) Date of filing: 02.11.2010
(51) Int. Cl.: H01L 25/075, F21K 99/00

(54) **Warm white light led lamp with high luminance and high color rendering index**

(30) Priority: 05.08.2010 CN 201010246490
(71) Applicant: Civilight Shenzhen Semiconductor Lighting Co., Ltd, Shenzhen, Guangdong (CN)
(72) Inventor: Xue, Xinshen, Guangdong (CN)
(74) Representative: MERH-IP Matias Erny Reichl Hoffmann

(57) **Abstract**

A warm white light LED lamp with high luminance and high color rendering index includes a drive circuit; a bracket; at least one LED wafer with wavelengths of 600nm-650nm fixed on the bracket; and at least one LED wafer with wavelengths of 380nm-470nm fixed on the bracket, wherein the LED wafers with wavelengths of 600nm-650nm and the LED wafers with wavelengths of 380nm-470nm are electrically coupled with the drive circuit by electrical wires, the LED wafer with wavelengths of 380nm-470nm is coated by a layer of fluorescent gel, the LED wafer with wavelengths of 600nm-650nm is coated by a layer of transparent gel, the layer of transparent silica gel overlays the layer of fluorescent gel, and a plane where the LED wafer with wavelengths of 600nm-650nm is disposed is higher or lower than a plane where the LED wafer with wavelengths of 380nm-470nm is disposed.

## Description

### TECHNICAL FIELD

The present invention relates to a semiconductor illumination device, and more particularly, to a warm white light LED lamp with high luminance and high color rendering index.

### BACKGROUND

Because the semiconductor illumination lamp has the characteristics of environmental protection, super long service life, high efficiency and energy saving, severe environment resistance, simple structure, small volume, light weight, fast response, low work voltage and good security, the semiconductor illumination lamp is regarded as the fourth generation of an illumination electric light source after a filament lamp, a fluorescent lamp and a power saving lamp, or as a green light source in the 21st century.

Currently, the warm white light which is suitable for illumination on the market is mainly made from LED wafers with wavelengths of 380-470nm and red fluorescent powder. The fluorescent powder is disposed in a center of a bracket cup of the LED. The dosage of the fluorescent powder is hardly to be exactly controlled in the prior art, thereby wasting large amount of the fluorescent powder, increasing the product cost, and hardly controlling the consistency in batch production.

Limited by the production process of the fluorescent powder, the luminous flux of the red fluorescent powder is very low, so that the light emitting efficiency (or light efficiency) of the warm white light is very low, and the color rendering index is approximately only from 70 to 80, thus, it is hard to meet the requirement of lighting products.

### SUMMARY

The object of the present patent application is to provide a warm white light LED lamp with high luminance and high color rendering index, thereby solving the problems of a traditional LED lamp with high cost, low lighting efficiency and low color rendering index.

One technical solution for solving the technical problem of the present patent application may be described as follows: a warm white light LED lamp with high luminance and high color rendering index includes a drive circuit; a bracket; at least one LED wafer with wavelengths of 600nm-650nm fixed on the bracket; and at least one LED wafer with wavelengths of 380nm-470nm fixed on the bracket, wherein the LED wafers with wavelengths of 600nm-650nm and the LED wafers with wavelengths of 380nm-470nm are electrically coupled with the drive circuit by electrical wires, the LED wafer with wavelengths of 380nm-470nm is coated by a layer of fluorescent gel, the LED wafer with wavelengths of 600nm-650nm is coated by a layer of transparent gel, the layer of transparent silica gel overlays the layer of fluorescent gel, and a plane where the LED wafer with wavelengths of 600nm-650nm is disposed is higher or lower than a plane where the LED wafer with wavelengths of 380nm-470nm is disposed.

Compared with the prior arts, in the present invention, the light efficiency and color rendering index of the warm white light LED lamp are improved by the following methods, thereby cutting cost of production. The methods may include: the number of the LED wafer with wavelengths of 600nm-650nm and the LED wafer with wavelengths of 380nm-470nm is reasonably adjusted, the LED wafer with wavelengths of 380nm-470nm is coated by a layer of fluorescent gel, the LED wafer with wavelengths of 600nm-650nm is coated by a layer of transparent gel and the layer of transparent silica gel overlays the layer of fluorescent gel, simultaneously, the plane where the LED wafer with wavelengths of 600nm-650nm is disposed is higher or lower than the plane where the LED wafer with wavelengths of 380nm-470nm is disposed. Therefore, the lighting efficiency can reach above 90Lm/W, and the color rendering index is above 90. The warm white light LED lamp with high luminance and high color rendering index has the following advantages: 1. the light efficiency of the LED lamp is at least improved by 25% compared with the light efficiency of the conventional LED lamp; 2. the present patent application can be used for producing middle or large power LED lamps whose power are above 0.1W. The LED lamp in accordance with the present patent application can effectively improve the reliability and the consistency of the product, and can be produced in bulk by a machine equipment, to thereby greatly improve the production efficiency, and reduce the product cost; 3. the present patent application can effectively control the dosage of the fluorescent gel, thereby not only being capable of increasing the light efficiency of the product, but also being capable of effectively saving cost; 4. the plane where the two LED wafers with wavelengths of 380nm-470nm are disposed is higher or lower than the plane where the three LED wafers with wavelengths of 600nm-650nm are disposed. the LED wafers are distinguished by different gel dispensing methods, thereby improving the light efficiency. The dosage of the silica gel and fluorescent powder can be effectively controlled, and the production cost is decreased. 5. the transparent gel may be molded to form a toroidal lens whose outer surface is a spheric face, and it is helpful to improve the light efficiency of the LED lamp. The warm white LED lamp is adapted for the lighting of outdoors, especially for the lighting in bars or exhibition halls and so on.

### BRIEF DESCRIPTION OF THE DRAWINGS

Other objects, advantages and novel features of the present invention will become more apparent from the following detailed description when taken in conjunction with the accompanying drawings, in which:

FIG. 1 is a sectional structure view of a first embodiment of the warm white light LED lamp with high luminance and high color rendering index;

FIG. 2 is another sectional structure view of the first embodiment of the warm white light LED lamp with high luminance and high color rendering index;

FIG. 3 is a sectional structure view of a second embodiment of the warm white light LED lamp with high luminance and high color rendering index;

FIG. 4 is another sectional structure view of the second embodiment of the warm white light LED lamp with high luminance and high color rendering index;

FIG. 5 is a sectional structure view of a third embodiment of the warm white light LED lamp with high luminance and high color rendering index;

FIG. 6 is a sectional structure view of a fourth embodiment of the warm white light LED lamp with high luminance and high color rendering index; and

FIG. 7 is a sectional structure view of a fifth embodiment of the warm white light LED lamp with high luminance and high color rendering index.

### DETAILED DESCRIPTION OF THE PREFERRED EMBODIMENTS

Objects, advantages and embodiments of the present invention will be explained below in detail with reference to the accompanying drawings. However, it is to be appreciated that the following description of the embodiment(s) is merely exemplary in nature and is no way intended to limit the invention, its application, or uses.

The warm white light LED lamp includes a bracket, a plurality of LED wafers securely welded on the bracket, a drive circuit (not shown) electrically coupled with the LED wafers. The LED wafers include an LED wafer with wavelengths of 600nm-650nm and an LED wafer with wavelengths of 380nm-470nm. The LED wafer with wavelengths of 380nm-470nm is coated by a layer of fluorescent gel, and the LED wafer with wavelengths of 600nm-650nm is coated by a layer of transparent gel. Furthermore, the layer of transparent silica gel overlays the layer of fluorescent gel. A plane where the LED wafer with wavelengths of 600nm-650nm is disposed is higher or lower than a plane where the LED wafer with wavelengths of 380nm-470nm is disposed.

The light efficiency and color rendering index of the warm white light LED lamp are improved by the following methods, thereby cutting cost of production. The methods include: the number of the LED wafer with wavelengths of 600nm-650nm and the LED wafer with wavelengths of 380nm-470nm is reasonably adjusted, the LED wafer with wavelengths of 380nm-470nm is coated by a layer of fluorescent gel, the LED wafer with wavelengths of 600nm-650nm is coated by a layer of transparent gel and the layer of transparent silica gel overlays the layer of fluorescent gel, simultaneously, the plane where the LED wafer with wavelengths of 600nm-650nm is disposed is higher or lower than the plane where the LED wafer with wavelengths of 380nm-470nm is disposed.

The present invention will be described in detail by enumerating a number of following embodiments.

### Embodiment 1:

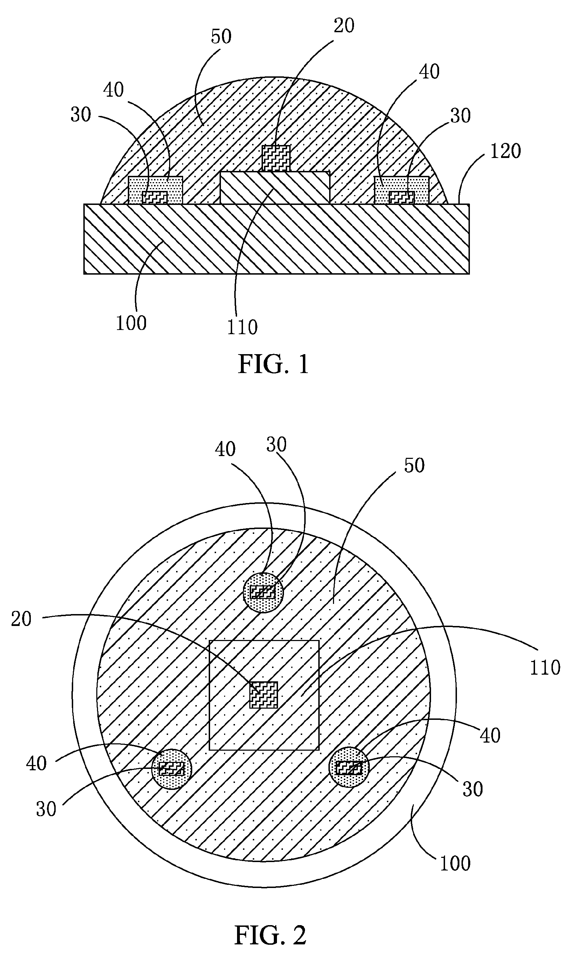

Referring to the FIGS. 1 and 2, in the first embodiment, the warm white light LED lamp with high luminance and high color rendering index includes a bracket 100, a plurality of LED wafers securely welded on the bracket, a drive circuit (not shown) electrically coupled with the LED wafers. The power of the LED lamp is above 0.1W. The middle of the bracket 100 is provided with a projecting portion 110 which is integrated with the bracket 100. The LED wafer 20 with wavelengths of 600nm-650nm is fixedly disposed on the projecting portion 110 of the bracket 100. The three LED wafers 30 with wavelengths of 380nm-470nm are located on an upper surface 120 of the bracket 100, and the three LED wafers 30 with wavelengths of 380nm-470nm are uniformly displaced around the projecting portion 110. An included angle of the two adjacent LED wafers 30 is 120 degree. Thus, it is convenient to weld the LED wafer 20 with wavelengths of 600nm-650nm and three LED wafers 30 with wavelengths of 380nm-470nm on the bracket 100. Therefore, the production efficiency is improved and the cost is decreased.

The LED wafer 20 with wavelengths of 600nm-650nm and three LED wafers 30 with wavelengths of 380nm-470nm are electrically coupled with the drive circuit by a plurality of electric wires. Only the three LED wafers 30 with wavelengths of 380nm-470nm are coated by a layer of fluorescent gel 40. The LED wafer 20 with wavelengths of 600nm-650nm and the whole bracket are coated by a layer of transparent gel 50 and the layer of transparent gel 50 overlays the layer of fluorescent gel 40. The fluorescent gel 40 is mixture of the transparent silica gel and the fluorescent powder, and the fluorescent powder is yellow powder, orange powder, red powder, green powder or RGB powder. The transparent gel 50 may be generally transparent silica gel or epoxide resin, and the transparent gel 50 is preferably transparent silica gel in the embodiments. In addition, the plane where the LED wafer 20 with wavelengths of 600nm-650nm is disposed is higher than the plane where the three LED wafers 30 with wavelengths of 380nm-470nm are disposed. The two different LED wafers have different fluid dispensing methods, and it is easy to distinguish the two different LED wafers. The dosage of the silica gel and fluorescent powder can be effectively controlled, and the production cost is decreased.

The light emitted from the LED wafer 20 with wavelengths of 600nm-650nm and the light generated by that the LED wafers 30 with wavelengths of 380nm-470nm excite the fluorescent gel 40 are mixed to produce the warm white light. Comparing with the light generated by that the LED wafers with wavelengths of 380nm-470nm excite the red fluorescent powder, the light efficiency and color rendering index are dramatically improved.

In the first embodiment, because the LED wafer 20 with wavelengths of 600nm-650nm is disposed on the projecting portion 110, the plane where the LED wafer 20 with wavelengths of 600nm-650nm is disposed is higher than the plane where the three LED wafers 30 with wavelengths of 380nm-470nm are disposed. The light emitted from the LED wafer 20 with wavelengths of 600nm-650nm can not be absorbed by the fluorescent gel 40 to thereby further improve the light efficiency of the LED lamp.

In the first embodiment, the transparent gel 50 may be molded to form a toroidal lens whose outer surface is a spheric face. In the light of the lens principle, the light emitted from the LED wafer 20 with wavelengths of 600nm-650nm and the light generated by that the LED wafers 30 with wavelengths of 380nm-470nm excite the fluorescent gel 40 are fully mixed to produce the warm white light. Thus, the light efficiency of the LED lamp is improved and the various color temperature requirements are met. In addition, the transparent silica gel 50 has higher refractive index to improve the light efficiency of the LED lamp.

### Embodiment 2:

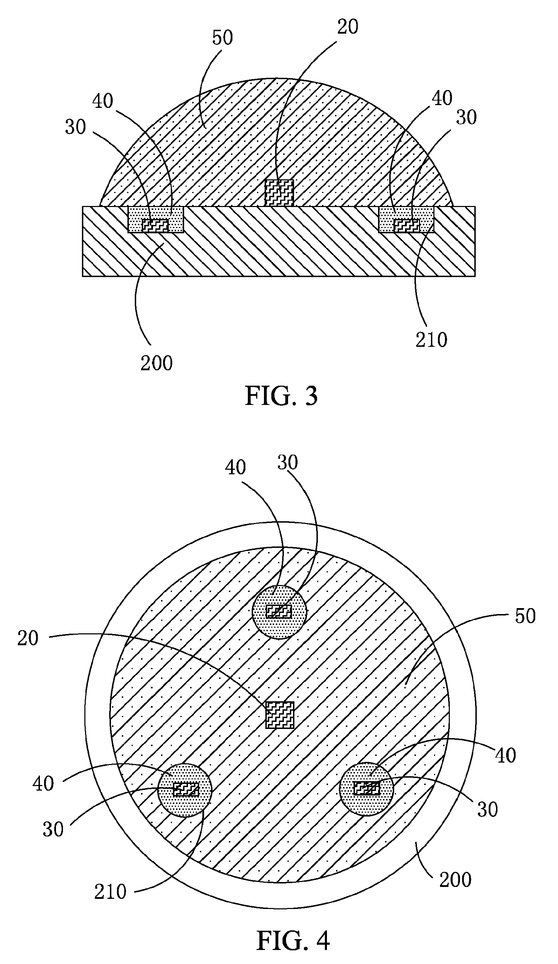

Referring to the FIGS. 3 and 4, in the second embodiment, the warm white light LED lamp with high luminance and high color rendering index includes a bracket 200, a plurality of LED wafers securely welded on the bracket, a drive circuit (not shown) electrically coupled with the LED wafers. The power of the LED lamp is above 0.1W. The bracket 200 is a cylinder in shape, and a middle of an upper surface of the bracket 200 defines three uniformly spaced grooves 210 in a circumference. The LED wafer 20 with wavelengths of 600nm-650nm is fixedly disposed on the middle of the bracket 200. The three LED wafers 30 with wavelengths of 380nm-470nm are respectively received in the corresponding groove 210 of the bracket 200, and the three LED wafers 30 with wavelengths of 380nm-470nm are uniformly displaced around the LED wafer 20. An included angle of the two adjacent LED wafers 30 is 120 degree.

In capsulation, the LED wafer 20 with wavelengths of 600nm-650nm and three LED wafers 30 with wavelengths of 380nm-470nm are electrically coupled with the drive circuit by a plurality of electric wires. After the fluorescent gel 40 is filled with the grooves 210 of the bracket 200, the three LED wafers 30 with wavelengths of 380nm-470nm are coated by a layer of fluorescent gel 40. The LED wafer 20 with wavelengths of 600nm-650nm and the whole bracket 200 are coated by a layer of transparent gel 50, and the layer of transparent gel 50 overlays the layer of fluorescent gel 40. In addition, the plane where the LED wafer 20 with wavelengths of 600nm-650nm is disposed is higher than the plane where the three LED wafers 30 with wavelengths of 380nm-470nm are disposed. The two different LED wafers have different fluid dispensing methods, and it is easy to distinguish the two different LED wafers. The dosage of the silica gel and fluorescent powder can be effectively controlled, and the production cost is decreased.

The light emitted from the LED wafer 20 with wavelengths of 600nm-650nm and the light generated by that the LED wafers 30 with wavelengths of 380nm-470nm excite the fluorescent gel 40 are mixed to produce the warm white light. Comparing with the light generated by that the LED wafers with wavelengths of 380nm-470nm excite the red fluorescent powder, the light efficiency and color rendering index are greatly improved.

In the second embodiment, because the three LED wafers 30 with wavelengths of 380nm-470nm are respectively received in the corresponding groove 210, the plane where the LED wafer 20 with wavelengths of 600nm-650nm is disposed is higher than the plane where the three LED wafers 30 with wavelengths of 380nm-470nm are disposed. The light emitted from the LED wafer 20 with wavelengths of 600nm-650nm can not be absorbed by the fluorescent gel 40 to thereby further improve the light efficiency of the LED lamp.

In the second embodiment, the transparent gel 50 may be molded to form a toroidal lens whose outer surface is a spheric face. According to the lens principle, the light emitted from the LED wafer 20 with wavelengths of 600nm-650nm and the light generated by that the LED wafers 30 with wavelengths of 380nm-470nm excite the fluorescent gel 40 are fully mixed to produce the warm white light. Thus, the light efficiency of the LED lamp is improved and the various color temperature requirements are met. In addition, the transparent silica gel 50 has higher refractive index to improve the light efficiency of the LED lamp.

### Embodiment 3:

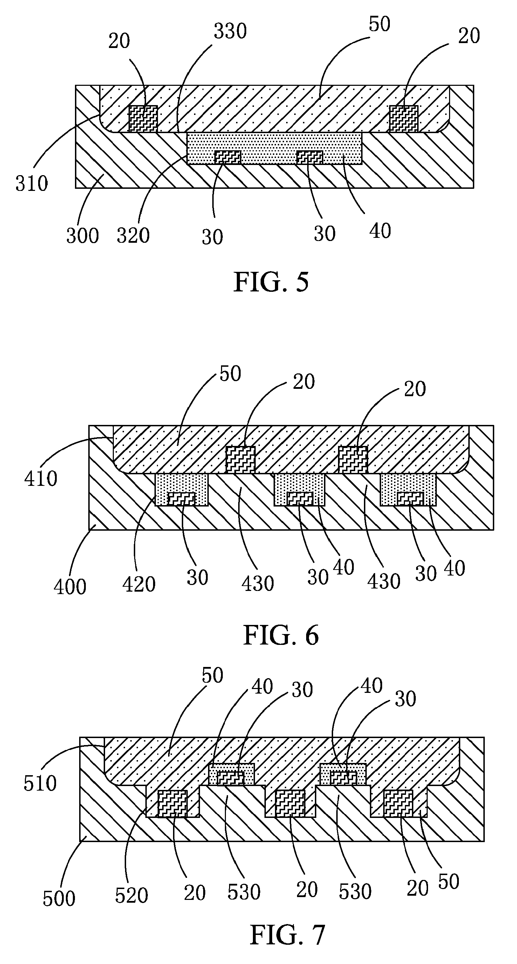

Referring to the FIG. 5, in the third embodiment, the warm white light LED lamp with high luminance and high color rendering index includes a bracket 300 defining a bracket cup 310 in a middle thereof, a plurality of LED wafers securely welded on the bracket, a drive circuit (not shown) electrically coupled with the LED wafers. The power of the LED lamp is above 0.1W. The bracket cup 310 defines a groove 320 in a middle thereof and is provided with a step 330 around the groove 320. The two spaced LED wafers 30 with wavelengths of 380nm-470nm are received in the groove 320 of the bracket cup 310. The two spaced LED wafers 20 with wavelengths of 600nm-650nm are located on the step 330 of the bracket cup 310.

In capsulation, the LED wafers 20 with wavelengths of 600nm-650nm and three LED wafers 30 with wavelengths of 380nm-470nm are electrically coupled with the drive circuit by a plurality of electric wires. After the fluorescent gel 40 is filled with the grooves 320 of the bracket 300, the three LED wafers 30 with wavelengths of 380nm-470nm are coated by a layer of fluorescent gel 40. Finally, the LED wafers 20 with wavelengths of 600nm-650nm and the whole bracket cup 310 are filled with transparent gel 50 and the layer of transparent gel 50 overlays the layer of fluorescent gel 40. The fluorescent gel 40 is mixture of the transparent silica gel and the fluorescent powder, and the fluorescent powder is yellow powder, orange powder, red powder, green powder or RGB powder.

The light emitted from the LED wafers 20 with wavelengths of 600nm-650nm and the light generated by that the LED wafers 30 with wavelengths of 380nm-470nm excite the fluorescent gel 40 are mixed to produce the warm white light. Comparing with the light generated by that the LED wafers with wavelengths of 380nm-470nm excite the red fluorescent powder, the light efficiency and color rendering index are greatly improved.

In the third embodiment, the plane where the LED wafers 20 with wavelengths of 600nm-650nm are disposed is higher than the plane where the three LED wafers 30 with wavelengths of 380nm-470nm are disposed. The light emitted from the LED wafers 20 with wavelengths of 600nm-650nm can not be absorbed by the fluorescent gel 40 to thereby further improve the light efficiency of the LED lamp. The two different LED wafers have different fluid dispensing methods, and it is easy to distinguish the two different LED wafers. The dosage of the silica gel and fluorescent powder can be effectively controlled, and the production cost is decreased.

### Embodiment 4:

Referring to the FIG. 6, in the fourth embodiment, the warm white light LED lamp with high luminance and high color rendering index includes a bracket 400 defining a bracket cup 410 in a middle thereof, a plurality of LED wafers securely welded on the bracket, a drive circuit (not shown) electrically coupled with the LED wafers. The power of the LED lamp is above 0.1W. The bracket cup 410 defines three spaced grooves 420 in a middle thereof and is provided with a step 430 between the two adjacent grooves 420. Each of the three LED wafers 30 with wavelengths of 380nm-470nm is respectively received in the corresponding groove 420 of the bracket cup 410. The two spaced LED wafers 20 with wavelengths of 600nm-650nm are respectively located on the step 430 of the bracket cup 410.

In capsulation, the LED wafers 20 with wavelengths of 600nm-650nm and three LED wafers 30 with wavelengths of 380nm-470nm are electrically coupled with the drive circuit by a plurality of electric wires. After the fluorescent gel 40 is filled with the grooves 420 of the bracket 400, the three LED wafers 30 with wavelengths of 380nm-470nm are coated by a layer of fluorescent gel 40. Finally, the LED wafers 20 with wavelengths of 600nm-650nm and the whole bracket cup 410 are filled with transparent gel 50, and the layer of transparent gel 50 overlays the layer of fluorescent gel 40. The fluorescent gel 40 is mixture of the transparent silica gel and the fluorescent powder, and the fluorescent powder is yellow powder, orange powder, red powder, green powder or RGB powder.

The light emitted from the LED wafers 20 with wavelengths of 600nm-650nm and the light generated by that the LED wafers 30 with wavelengths of 380nm-470nm excite the fluorescent gel 40 are mixed to produce the warm white light. Comparing with the light generated by that the LED wafers with wavelengths of 380nm-470nm excite the red fluorescent powder, the light efficiency and color rendering index are greatly improved.

In the fourth embodiment, the plane where the LED wafers 20 with wavelengths of 600nm-650nm are disposed is higher than the plane where the three LED wafers 30 with wavelengths of 380nm-470nm are disposed. The light emitted from the LED wafers 20 with wavelengths of 600nm-650nm can not be absorbed by the fluorescent gel 40 to thereby further improve the light efficiency of the LED lamp. The two different LED wafers have different fluid dispensing methods, and it is easy to distinguish the two different LED wafers. The dosage of the silica gel and fluorescent powder can be effectively controlled, and the production cost is decreased.

### Embodiment 5:

Referring to the FIG. 7, in the fourth embodiment, the warm white light LED lamp with high luminance and high color rendering index includes a bracket 500 defining a bracket cup 510 in a middle thereof, a plurality of LED wafers securely welded on the bracket, a drive circuit (not shown) electrically coupled with the LED wafers. The power of the LED lamp is above 0.1W. The bracket cup 510 defines three spaced grooves 520 in a middle thereof and is provided with a step 530 between the two adjacent grooves 520. Each of the three LED wafers 20 with wavelengths of 600nm-650nm is respectively received in the corresponding groove 520 of the bracket cup 510. The two spaced LED wafers 30 with wavelengths of 380nm-470nm are respectively located on the step 530 of the bracket cup 510.

In capsulation, the LED wafers 20 with wavelengths of 600nm-650nm and three LED wafers 30 with wavelengths of 380nm-470nm are electrically coupled with the drive circuit by a plurality of electric wires. Firstly, the three LED wafers 30 with wavelengths of 380nm-470nm are coated by a layer of fluorescent gel 40, and then, the whole bracket cup 510 and the three grooves 520 are filled with transparent gel 50 and the layer of transparent gel 50 overlays the layer of fluorescent gel 40 and the LED wafers 20 with wavelengths of 600nm-650nm. The fluorescent gel 40 is mixture of the transparent silica gel and the fluorescent powder, and the fluorescent powder is yellow powder, orange powder, red powder, green powder or RGB powder.

The light emitted from the LED wafers 20 with wavelengths of 600nm-650nm and the light generated by that the LED wafers 30 with wavelengths of 380nm-470nm excite the fluorescent gel 40 are mixed to produce the warm white light. Comparing with the light generated by that the LED wafers with wavelengths of 380nm-470nm excite the red fluorescent powder, the light efficiency and color rendering index are greatly improved.

In the fifth embodiment, the plane where the two LED wafers 30 with wavelengths of 380nm-470nm are disposed is higher than the plane where the three LED wafers 20 with wavelengths of 600nm-650nm are disposed. The light emitted from the LED wafers 20 with wavelengths of 600nm-650nm can not be absorbed by the fluorescent gel 40 to thereby further improve the light efficiency of the LED lamp. The two different LED wafers have different fluid dispensing methods, and it is easy to distinguish the two different LED wafers. The dosage of the silica gel and fluorescent powder can be effectively controlled, and the production cost is decreased.

In the above-mentioned five embodiments, by reasonably allocating the quantitative proportion and the mutual position relationship between the LED wafers with wavelengths of 600-650nm and the LED wafers with wavelengths of 380-470nm, the beams emitted from the red light wafer or the orange light wafer are mixed together, therefore, the lighting efficiency can reach above 90Lm/W, and the color rendering index is above 90. Furthermore, according to the luminance of the red light wafer and actual demand, the fluorescent gel and the transparent gel coated on the LED wafers are adjusted to meet the requirements of various color temperatures. Therefore, the warm white light with color temperature of 1400K-4500K may be obtained.

In the present invention, the light efficiency and color rendering index of the warm white light LED lamp are improved by the following methods, thereby cutting production cost. The methods include: the number of the LED wafer with wavelengths of 600nm-650nm and the LED wafer with wavelengths of 380nm-470nm is reasonably adjusted, the LED wafer with wavelengths of 380nm-470nm is coated by a layer of fluorescent gel, the LED wafer with wavelengths of 600nm-650nm is coated by a layer of transparent gel, and the layer of transparent silica gel overlays the layer of fluorescent gel. Simultaneously, the plane where the LED wafer with wavelengths of 600nm-650nm is disposed is higher or lower than the plane where the LED wafer with wavelengths of 380nm-470nm is disposed. Therefore, the lighting efficiency can reach above 90Lm/W, and the color rendering index is above 90. The warm white light LED lamp with high luminance and high color rendering index has the following advantages: 1. the light efficiency of the LED lamp is at least improved by 25% compared with the light efficiency of the conventional LED lamp; 2. the present patent application can be used for producing middle or large power LED lamps whose power are above 0.1W. The LED lamp in accordance with the present patent application can effectively improve the reliability and the consistency of the product, and can be produced in bulk by a machine equipment, to thereby greatly improve the production efficiency, and reduce the product cost; 3. the present patent application can effectively control the dosage of the fluorescent gel, thereby not only being capable of increasing the light efficiency of the product, but also being capable of effectively saving cost; and 4. the plane where the two LED wafers with wavelengths of 380nm-470nm are disposed is higher or lower than the plane where the three LED wafers with wavelengths of 600nm-650nm are disposed. the LED wafers are distinguished by different gel dispensing methods, thereby improving the light efficiency. The dosage of the silica gel and fluorescent powder can be effectively controlled, and the production cost is decreased. 5. the transparent gel may be molded to form a toroidal lens whose outer surface is a spheric face, and it is helpful to improve the light efficiency of the LED lamp. The warm white LED lamp is adapted for the lighting of outdoors, especially for the lighting in bars or exhibition halls and so on.

The present invention may be embodied in other forms without departing from the spirit or novel characteristics thereof. The embodiments disclosed in this application are to be considered in all respects as illustrative and not limitative. The scope of the invention is indicated by the appended claims rather than by the foregoing description; and all changes which come within the meaning and range of equivalency of the claims are intended to be embraced therein.
Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A warm white light LED lamp with high luminance and high color rendering index comprising:
a drive circuit;
a bracket (100);
at least one LED wafer (20) with wavelengths of 600nm-650nm fixed on the bracket (100; 200; 300; 400; 500); and
at least one LED wafer (30) with wavelengths of 380nm-470nm fixed on the bracket (100; 200; 300; 400; 500), wherein the LED wafers (20) with wavelengths of 600nm-650nm and the LED wafers (30) with wavelengths of 380nm-470nm are electrically coupled with the drive circuit by electrical wires, the LED wafer (30) with wavelengths of 380nm-470nm is coated by a layer of fluorescent gel (40), and the LED wafer (20) with wavelengths of 600nm-650nm is coated by a layer of transparent gel (50), the layer of transparent silica gel (50) overlays the layer of fluorescent gel (40), and a plane where the LED wafer (20) with wavelengths of 600nm-650nm is disposed is higher or lower than a plane where the LED wafer (30) with wavelengths of 380nm-470nm is disposed.

2. The warm white light LED lamp as claimed in claim 1, wherein the bracket (100) is provided with a projecting portion (110) thereon, the LED wafer (30) with wavelengths of 380nm-470nm is located on an upper surface of the bracket (100), and the LED wafer (20) with wavelengths of 600nm-650nm is displaced on the projecting portion (110).

3. The warm white light LED lamp as claimed in claim 2, wherein the projecting portion (110) is formed on a middle of the bracket (100), at least three LED wafers (30) with wavelengths of 380nm-470nm are uniformly displaced around the projecting portion (110).

4. The warm white light LED lamp as claimed in at least one of claims 1 to 3, wherein the bracket (200) defines at least one groove (210), the LED wafer (30) with wavelengths of 380nm-470nm is received in the at least one groove (210) of the bracket (200), and the LED wafer (20) with wavelengths of 600nm-650nm is displaced on an upper surface of the bracket (200).

5. The warm white light LED lamp as claimed in claim 4, wherein the bracket (200) defines three uniform spaced grooves (210) around the LED wafer (20) with wavelengths of 600nm-650nm, the LED wafers (30) with wavelengths of 380nm-470nm are respectively received in the corresponding groove (210) of the bracket (200), and the LED wafers (20) with wavelengths of 600nm-650nm are displaced on a middle of the upper surface of the bracket (200).

6. The warm white light LED lamp as claimed in at least one of claims 1 to 5, wherein the bracket (300) defines a bracket cup (310) therein, the bracket cup defines a groove (320) in a middle thereof and is provided with a step around the groove, the spaced LED wafers (30) with wavelengths of 380nm-470nm are received in the groove of the bracket cup (310), and the groove (320) is filled with the fluorescent gel (40), the LED wafer (20) with wavelengths of 600nm-650nm is located on the step of the bracket cup (310), the LED wafers (20) with wavelengths of 600nm-650nm and the whole bracket cup (310) are filled with transparent gel (50), and the layer of transparent gel (50) overlays the layer of fluorescent gel (40) and the LED wafer (20) with wavelengths of 600nm-650nm.

7. The warm white light LED lamp as claimed in at least one of claims 1 to 6, wherein the bracket (400) defines a bracket cup (410) therein, the bracket cup defines a plurality of grooves (420) in a middle thereof and is provided with a plurality of steps (430) between the adjacent grooves, the LED wafer (30) with wavelengths of 380nm-470nm are respectively received in the corresponding groove of the bracket cup (410), and the grooves are filled with the fluorescent gel (40), the LED wafers (20) with wavelengths of 600nm-650nm are respectively located on the corresponding step of the bracket cup (410), the whole bracket cup (410) is filled with transparent gel (50), and the layer of transparent gel (50) overlays the layer of fluorescent gel (40) and the LED wafers (20) with wavelengths of 600nm-650nm.

8. The warm white light LED lamp as claimed in at least one of claims 1 to 7, wherein the bracket (500) defines a bracket cup (510) therein, the bracket cup (510) defines a plurality of grooves (520) in a middle thereof and is provided with a plurality of steps (530) between the adjacent grooves (520), the LED wafers (30) with wavelengths of 380nm-470nm are respectively located on the corresponding step of the bracket cup (520), the LED wafer (20) with wavelengths of 600nm-650nm are respectively received in the corresponding groove of the bracket cup (510), and the grooves are filled with the fluorescent gel (40), the whole bracket cup (510) is filled with transparent gel (50), and the layer of transparent gel (50) overlays the layer of fluorescent gel (40) and the LED wafers (20) with wavelengths of 600nm-650nm.

9. The warm white light LED lamp as claimed in at least one of claims 1 to 8, wherein the transparent gel (50) is molded to form a toroidal lens whose outer surface is a spheric face.

10. The warm white light LED lamp as claimed in at least one of claims 1 to 9, wherein the fluorescent gel (40) is mixture of the transparent silica gel and the fluorescent powder, and the fluorescent powder is yellow powder, orange powder, red powder, green powder or RGB powder.
